Europäisches Patentamt

European Patent Office

Office européen des brevets

(11) Publication number: **0 436 184 A2**

# EUROPEAN PATENT APPLICATION

(21) Application number: 90124819.5

(51) Int. Cl.⁵: **H01L 21/225**

(22) Date of filing: **19.12.90**

(30) Priority: **20.12.89 JP 330429/89**

(43) Date of publication of application:
**10.07.91 Bulletin 91/28**

(84) Designated Contracting States:
**DE FR GB**

(71) Applicant: **FUJITSU LIMITED**
**1015, Kamikodanaka Nakahara-ku**
**Kawasaki-shi Kanagawa 211(JP)**

(72) Inventor: **Miura, Takao, c/o Fujitsu Limited**
**Patent Dept.**
**1015 Kamikodanaka, Nakahara-ku**
**Kawasaki-shi, Kanagawa 211(JP)**

(74) Representative: **Sunderland, James Harry et al**
**Haseltine Lake & Co Hazlitt House 28,**
**Southampton Buildings Chancery Lane**
**London WC2A 1AT(GB)**

(54) Method of manufacturing a semiconductor device utilising an impurity segregation phenomenon.

(57) A method of manufacturing a semi conductor device, the device comprising a silicon substrate (1) and an insulation layer (2; 2b; 11; 24; 32) formed on the substrate, the method comprising:-
depositing a conductive layer (4; 21) on the insulation layer (2; 2b; 11; 24; 32), which conductive layer (4; 21) is doped with an impurity material (5);
carrying out heat treatment such that the impurity material (5) segregates and accumulates in the insulation layer (2) and fixed charges (6) are formed in the insulation layer (2; 2b; 11; 24; 32).

FIG. 1(a)

FIG. 1(b)

FIG. 1(c)

EP 0 436 184 A2

# METHOD OF MANUFACTURING A SEMICONDUCTOR DEVICE UTILISING AN IMPURITY SEGREGATION PHENOMENON.

The present invention relates to a method of manufacturing a semiconductor device utilising an impurity segregation phenomenon, and device structures produced by the method.

When a silicon dioxide ($SiO_2$) layer is formed on a p-type silicon (Si) substrate, a depletion/inversion layer is formed in the silicon substrate in the close vicinity of the Si/SiO₂ interface. This layer is considered to be formed as a result of the occurrence of an interface state due to $Si_xO_y{}^+$ at the Si/SiO₂ interface. When this type of depletion layer is formed on a surface of an element isolation structure in the substrate, the isolating function of the structure deteriorates with the result that a leakage current can flow through the depletion/inversion layer. Between MIS (metal insulator semiconductor) transistors, for example, if a leakage current flows between source/drain regions of adjacent transistors, normal operation cannot be expected.

As one method intended to solve the above problem, it has been proposed that the p-type silicon substrate be subjected to the introduction of a high density of p-type impurity, such as boron (B), on the substrate side of Si/SiO₂ interface, the introduced p-type impurity contributing to the prevention of generation of the depletion layer. However, impurities such as boron (B) easily diffuse into the silicon substrate and spread into element-forming regions, which will reduce the effective available element-forming area. In an MIS transistor, if channel width is made narrower than the design objective, which is called a narrow channel effect, the expected driving power of the transistor cannot be obtained.

As another method intended to prevent the occurrence of such a depletion/inversion layer, the inventor of the present invention and others have made proposals for a method involving a direct introduction of aluminium (Al) ions into the SiO₂ layer of the Si/SiO₂ interface (disclosed in Japanese patent disclosures Tokugan Sho 63-009458, Tokugan Sho 63-236025, Tokugan Sho 63-310457, etc.).

The above proposals are based on the theory that Al impurities form negative fixed charges in the SiO₂ layer, and therefore carriers in the p-type silicon substrate are attracted thereto and there is hardly any change of the formation of a depletion layer adjacent to the interface.

In order to introduce Al impurities into the SiO₂ layer, a chemical dipping method, involving dipping into an aluminium-containing solution, and a method of direct ion implantation into the SiO₂ layer have been proposed.

An indirect method has also been proposed in which a polysilicon layer is deposited on a SiO₂ layer and Al impurities are introduced by an ion implantation into the polysilicon layer and thermally diffused into the SiO₂ layer. In accordance with this method, Al can be introduced by a dry process, and the method is not accompanied by difficulty of controlling depth of ion implantation as required in the direct ion implantation method.

In the method of direct ion implantation, the Al should be introduced without penetration through the SiO₂ layer. To guarantee this, the SiO₂ layer should have a thickness greater than 1000 Å. On the other hand, Al ions should be introduced within a region of 50-100 Å from Si/SiO₂ interface. It is very difficult to control the depth of ion implantation to meet the above conditions. However, with the method utilising a polysilicon layer as a diffusion source and diffusing the Al into the SiO₂ layer, Al ion punch-through to the SiO₂ layer will not occur, and therefore the thickness of the SiO₂ layer can be reduced to as little as 50 Å and the negative fixed charges formed by Al impurities show a remarkable effect.

In the proposed indirect method, the polysilicon layer used as the Al diffusion source is oxidised during or after the diffusion process, which results in formation of a SiO₂ layer converted from the polysilicon layer.

An embodiment of the present invention can provide a method of forming and confining fixed charges in an insulation layer formed on a Si substrate utilising a segregation characteristic of impurities as between Si and the insulation layer, without oxidation of the Si and like material.

An embodiment of the present invention can provide a method of preventing formation of a depletion/inversion layer in the Si substrate in close vicinity to an interface between the Si substrate and an insulation layer thereon.

In an embodiment of the present invention, an insulation layer of silicon dioxide, for example, is formed in contact with a silicon substrate and it is required to avoid formation of a depletion or inverted layer in the silicon substrate adjacent to the interface between the insulation layer and the silicon. To this end, an impurity segregation phenomenon is utilised in the manufacturing method of the embodiment.

Trench isolation structures and field isolation structures of semi conductor devices, MIS transistors having precisely controlled threshold voltages and memory devices having an improved write/read characteristics can be provided using embodiments of the present invention.

An embodiment of the present invention can provide a method of utilising a conductive layer of polysilicon, for example, formed on an insulation layer as an impurity source and subsequently using the conductive layer as an electrode after impurities have been redistributed into the insulation layer in a segregation process.

An embodiment of the present invention can provide a semiconductor device which is manufactured by the above method, resulting in obtaining the semiconductor device having an improved characteristic.

A manufacturing method embodying the present invention comprises the steps of:-

depositing an insulation layer on a silicon substrate and further providing a conductive layer thereon,

doping impurities in the conductive layer, the impurities being selected from materials which are susceptible to segregate and to pile up or accumulate easily into the insulation layer rather than in the Si substrate and the conductive layer, and

heat treating the substrate, whereby the impurities are redistributed into the insulation layer and negative (or positive) fixed charges are formed in the insulation layer, resulting in prevention of formation of a depletion/inversion layer in the Si substrate adjacent to the interface between the Si substrate and the insulation layer.

In such a method, when a p-type Si substrate is used, Al, calcium (Ca) or strontium (Sr) impurities may be introduced into the conductive layer as the impurities, and negative fixed charges are formed in the insulation layer and a $p^+$ layer is induced in the Si substrate adjacent to the interface with the insulation layer.

Boron (B) impurities may be used for forming positive fixed charges.

In such a method, the conductive layer used as an impurity source is subsequently utilised as a conductive electrode of a semiconductor device. This is particularly useful for manufacturing a MIS FET device, wherein the aforementioned insulation layer and the conductive layer are used as a gate insulation layer and a gate electrode.

Reference is made, by way of example, to the accompanying drawings, in which:-

Figs. 1(a) to 1(c) and 2(a) to 2(c) are schematic cross-sectional views illustrating in outline embodiments of the present invention;

Figs. 3(a) and 3(b) are graphs illustrating segregation characteristics of aluminium impurities in a silicon-substrate/$SiO_2$-layer/polysilicon-layer structure for assistance in understanding the present invention;

Figs. 4(a) to 4(e) and Fig. 5 are schematic cross-sectional views illustrating manufacturing steps of an embodiment of the present invention which affords a trench isolation structure;

Figs. 6(a) to 6(e) and Fig. 7 are schematic cross-sectional views illustrating manufacturing steps of an embodiment of the present invention which affords a field isolation structure;

Figs. 8(a) to 8(c) are schematic cross-sectional views illustrating manufacturing steps of an embodiment of the present invention which affords a MOS transistor structure;

Figs. 9(a) and 9(b) are schematic cross-sectional views illustrating manufacturing steps of an embodiments of the present invention which affords a CMOS transistor structure;

Figs. 10(a) and 10(b) are schematic cross-sectional views illustrating manufacturing steps of an embodiment of the present invention which affords a MASK ROM structure;

Figs. 11(a) to 11(d) are schematic cross sectional views illustrating manufacturing steps of an embodiment of the present invention which affords an EEPROM structure.

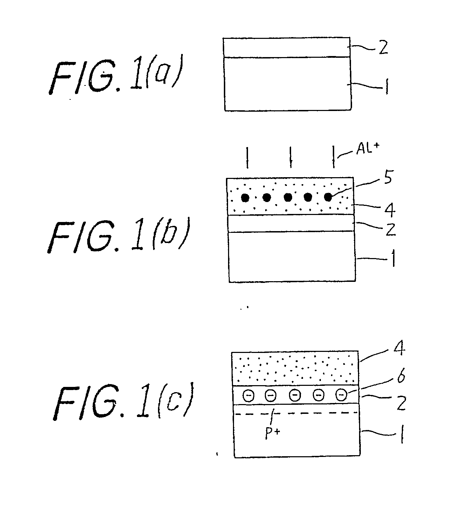

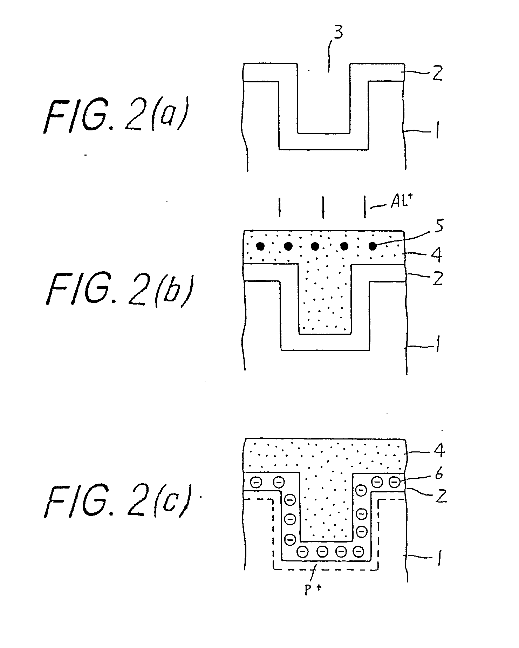

Outlines of two embodiments of the present invention will first be given with reference to Figs. 1 and 2.

Fig. 1(a) shows a $SiO_2$ layer 2 formed on a p-type silicon substrate 1 by thermally oxidising the surface of the substrate 1. Next, as shown in Fig. 1(b), a polysilicon layer 4 having a thickness of about 3000 Å is deposited on the $SiO_2$ layer 2 and thereafter Al ions are implanted into the polysilicon layer 4. In the Figure, the implanted Al atoms 5 are schematically shown by black dots. Next, the silicon substrate 1 is subjected to thermal treatment in nitrogen atmosphere at a temperature higher than 950°C. In this treatment, Al atoms 5 in the polysilicon layer 4 move into the $SiO_2$ layer 2 and pile up therein. The phenomenon of this sort is known as redistribution or segregation of impurities between Si and $SiO_2$ layers. The Al impurities introduced into the $SiO_2$ react with oxygen atoms and negative fixed charges 6 are formed therein which are shown in Fig. 1(c). Due to the negative fixed charges 6, a $p^+$ region is formed in the substrate 1 adjacent to interface with the $SiO_2$ layer. The fact that Al atoms introduced into the $SiO_2$ layer form negative fixed charges can be confirmed by a decrease of a leakage current in a MIS transistor when Al atoms are introduced in an $SiO_2$ layer in an element isolation region.

Figs. 2(a) to 2(c) illustrate a case in which negative fixed charges 6 are formed in a $SiO_2$ layer 2 formed in a trench 3 of a p-type silicon substrate 1 by a method similar to that applied in the case of Figs. 1(a) to 1(c). The trench 3 is filled with a polysilicon layer 4 into which Al ions are introduced, and Al atoms are thermally diffused into the $SiO_2$ layer 2 and form negative fixed charges 6, resulting in formation of a $p^+$ region around the trench 3. In accordance with the above method, Al ions are uniformly introduced into the $SiO_2$ layer 2 forming the side walls of the trench 3, because there is no shadow effect in the thermal diffusion such as would arise with ion implantation.

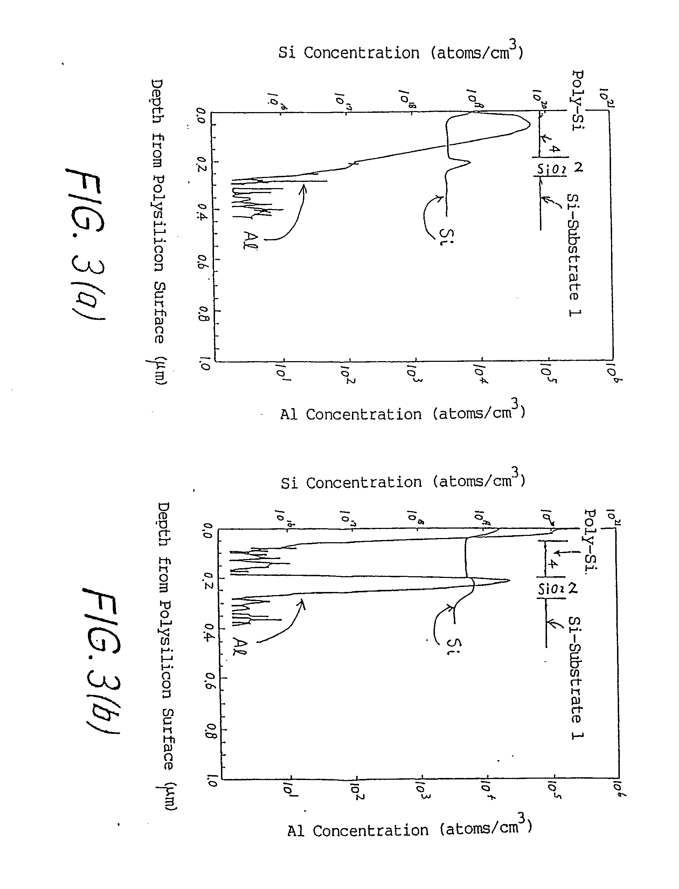

Figs. 3(a) and 3(b) are graphs which show Si and Al concentration curves at different distances from the surface of polysilicon layer 4, going into the underlying $SiO_2$ layer 2 and further into the Si substrate 1. Fig. 3(a) shows concentration distribution curves which apply after the polysilicon layer 4 has been subjected to Al ion implantation without heat treatment, and Fig. 3(b) shows concentration distribution curves which apply after a thermal treatment at $1000°C$ for 60 minutes in nitrogen atmosphere. For obtaining the data illustrated in Figs. 3(a) and 3(b) the thicknesses of the $SiO_2$ layer 2 and the polysilicon layer 4 were about 0.1 and 0.2 microns respectively and the Al implantation was performed under the conditions of 40 KeV ion energy and $5 \times 10^{14} cm^{-2}$ dose density. On the surface of polysilicon layer 4, a natural Si oxide film is formed.

Before the thermal treatment, Al impurities are distributed more or less uniformly throughout the natural oxide film and the polysilicon layer 4. However, after thermal treatment, a peak of Al distribution is found in the natural Si oxide film and the $SiO_2$ layer 2, and the Al concentration in the polysilicon layer 4 and the silicon substrate 2 is less than the peak value by three to four orders of magnitude and may be regarded as corresponding to a noise level. Namely, Al impurities are segregated into the natural Si oxide film and the $SiO_2$ layer 2, and do not remain in the polysilicon layer 4 and the silicon substrate 1.

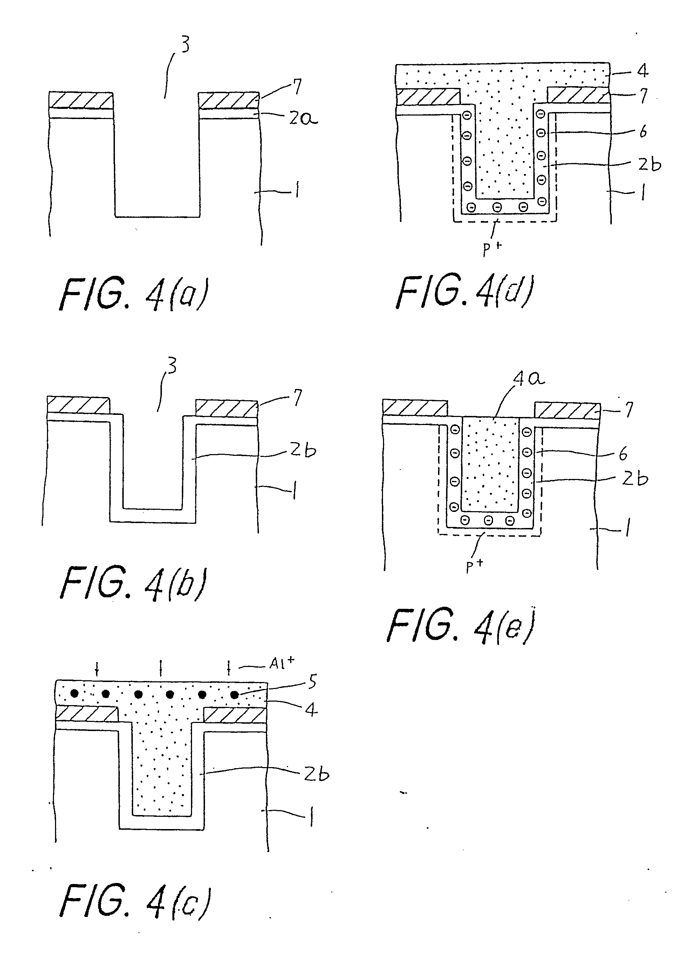

Figs. 4(a) to 4(e) are schematic cross-sectional views illustrating manufacturing steps in accordance with an embodiment of the present invention, in which a trench isolation structure is formed in a silicon substrate.

Referring to Fig. 4(a), a $SiO_2$ layer 2a and a $Si_3N_4$ layer 7 are formed sequentially on a silicon substrate 1. Thereafter the $Si_3N_4$ layer 7 and the $SiO_2$ layer 2a are subjected to selective etching and removing processes using known lithography techniques, and a trench 3 is formed by further removal of the exposed surface of silicon substrate 1.

Next, using the $Si_3N_4$ layer 7 as a mask as shown in Fig. 4(b), the exposed silicon substrate 1 in the trench 3 is thermally oxidised resulting in the formation of an $SiO_2$ layer 2b of about 500 Å thickness. Then a polysilicon layer 4 is deposited by a known CVD (chemical vapour deposition) method on an entire surface of the silicon substrate 1 as shown in Fig. 4(c). In this process, the trench 3 is filled with the polysilicon layer 4.

Next, Al ions are implanted into the polysilicon layer 4.

Of course, an Al-doped polysilicon layer 4 can be deposited in the process of Fig. 4(c).

The above ion implantation should be performed such that the Al ions do not penetrate through the polysilicon layer 4. Al ions can easily diffuse in polysilicon and therefore it is sufficient for Al ions 5 to be implanted in the surface region of the polysilicon layer 4 with the necessary dose amount. The conditions therefor are, for example, an ion energy of 40 KeV and a dose density of $1 \times 10^{16} cm^{-2}$. After ion implantation, the silicon substrate 1 is subjected to thermal treatment of, for example, $950°C$ and 20 minutes in nitrogen atmosphere. As a result, Al in the polysilicon layer 4 piles up in the $SiO_2$ layer 2b and forms negative fixed charges 6 as shown in Fig. 4(d). These negative fixed charges 6 induce a $p^+$ region in the close vicinity of the trench 3 in the substrate 1, which prevents leakage between element-forming regions separated by the trench isolation.

After these processes, the polysilicon layer 4 on the surface of substrate 1 is etched back by a known anisotropic etching technique, to leave the polysilicon layer 4a only in the trench 3, as shown in Fig. 4(e). This polysilicon layer 4a is utilised as a diffusion source of Al impurities and a filling material into the trench.

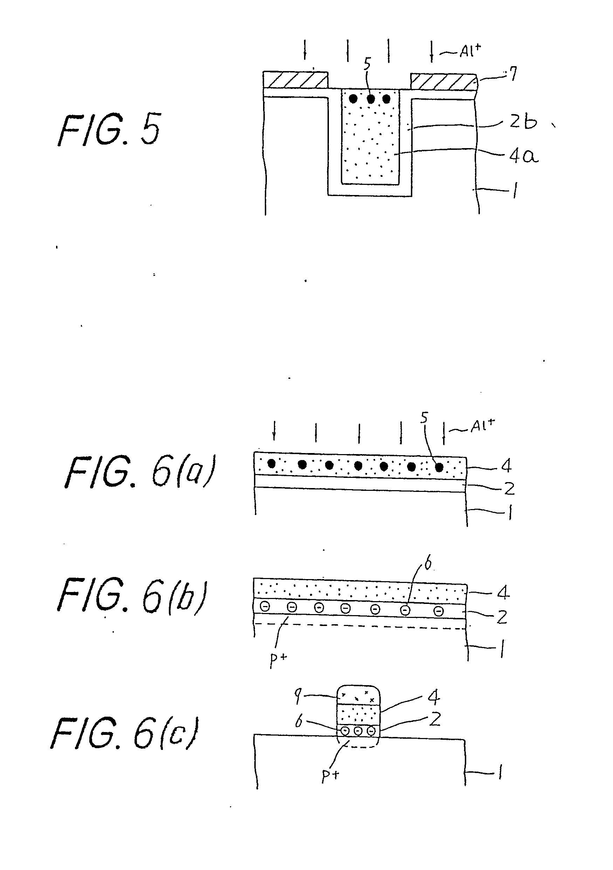

The above method of Figs. 4(a) to 4(e) can be slightly modified. As shown in Fig. 5, the polysilicon layer may be etched back to leave only a polysilicon layer 4a in the trench, then Al atoms 5 can be ion implanted and, thereafter, the substrate thermally treated as in the embodiment described with reference to Figs. 4, resulting in piling up Al impurities in the $SiO_2$ layer 2b.

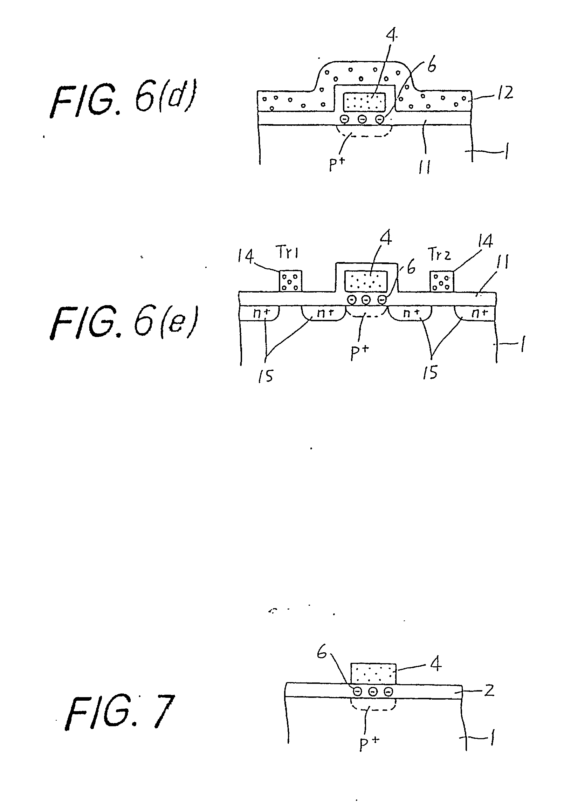

Figs. 6(a) to 6(e) show schematic cross-sectional views of manufacturing steps in accordance with another embodiment of the present invention. This embodiment represents an application of the present invention for forming a field isolation structure. A $p^+$ region is formed in a p-type Si substrate 1 in the close vicinity of the surface thereof, the $p^+$ region serving as an element isolation region.

As shown in Fig. 6(a), a $SiO_2$ layer 2 having a thickness of about 1000 Å and a polysilicon layer 4 having a thickness of about 3000 Å are formed on the surface of the silicon substrate 1. Thereafter, Al atoms 5 are ion implanted on to the entire surface of the polysilicon layer 4. The conditions of ion implantation may be the same as those applied in the embodiment described above with reference to Figs. 4 and 5. Next, the silicon substrate 1 is thermally treated and Al ions in the polysilicon layer 4 pile up in the $SiO_2$ layer 2. The conditions of thermal treatment may be the same as those used in the embodiment described above with reference to Figs. 4 and 5. As a result, negative fixed charges 6 are formed in the $SiO_2$ layer 2 and a $p^+$ region is induced in the silicon substrate 1 just under the $SiO_2$ layer 2 as shown in Fig. 6(b).

Next, a resist layer 9 is formed on the entire surface of the substrate and is selectively removed leaving a patterned resist layer 9 which covers a field isolation region, using known lithography techniques. The polysilicon layer 4 and $SiO_2$ layer 2 exposed beyond the patterned resist layer 9 are removed by a known etching technique, and a structure such as shown in Fig. 6(c) is formed. A field isolation $p^+$ region, which is induced by the negative fixed charges in the $SiO_2$ layer 2, is formed in the Si substrate 1.

After removing the resist layer 9, the surface of the Si substrate 1 is oxidised thermally and a gate insulation layer 11 of Si dioxide is formed as shown in Fig. 6(d). The Si dioxide layer 11 is also formed on the surface of the polysilicon layer 4 in the field isolation region. Thereafter, another polysilicon layer 12 is deposited on the entire surface of the silicon substrate 1. This polysilicon layer 12 is selectively etched away, leaving gate electrodes 14 in element forming areas as shown in Fig. 6(e).

Next, n-type impurities of, for example, arsenic (As) are ion implanted into the Si substrate 1 using as a mask the remaining polysilicon layer 4 in the field isolation region and the gate electrodes 14. Thus, MOS transistors $Tr_1$ and $Tr_2$ having source and drain regions 15 are formed. The n-type source and drain regions 15 of these MOS transistors are isolated from each other by the $p^+$ region in the field isolation region. With this structure it is difficult for a leakage current between the transistors $Tr_1$ and $Tr_2$ to develop.

In the embodiment of Figs. 6, thermal treatment for redistributing the Al ions into the $SiO_2$ layer 2 may be performed after etching of the polysilicon layer 4 and the $SiO_2$ layer 2, i .e. after the step of Fig. 6(c). In this case, the etching process may be performed for the polysilicon layer 4 only, and the $SiO_2$ layer 2 may be left on the entire surface of the Si substrate 1 as shown in Fig. 7. This modified method of leaving the $SiO_2$ layer 2 on the entire surface of the Si substrate 1 has the merits of alleviating damage to the substrate and reducing defects. When a negative voltage is applied to the polysilicon layer 4, isolation characteristic is enhanced with the structure of Figs. 6 and 7.

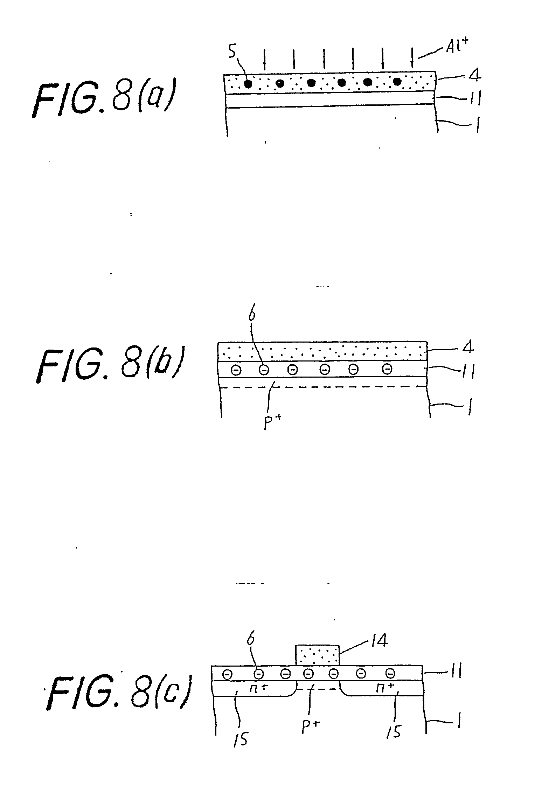

Figs. 8(a) to 8(c) illustrate another method in accordance with an embodiment of the present invention, which provides for controlling the threshold voltage $V_{th}$ of a MOS transistor.

As shown in Fig. 8(a), after forming a gate insulation layer 11 on a p-type Si substrate, the gate insulation layer having a thickness of about 200 Å, a polysilicon layer 4 of about 3000 Å in thickness is deposited on the entire surface of the Si substrate 1. Next, Al atoms 5 are ion implanted in the polysilicon layer 4, and thereafter the Si substrate 1 is subjected to thermal treatment. Al ions in the polysilicon layer 4 pile up in the gate insulation layer 11 and negative fixed charges are formed in the gate insulation layer 11 as shown in Fig. 8(b). The ion implantation conditions used may be an ion energy of 40 KeV and a dose density of $1 \times 10^{16} cm^{-2}$, and the conditions for thermal treatment may be $950°C$ and 20 minutes in nitrogen atmosphere.

Next, the polysilicon layer 4 is patterned by a known lithography technique and a gate electrode 14 is formed as shown in Fig. 8(c). N-type impurities of As for example are ion implanted into the Si substrate 1, and source and drain regions 15 are formed. The conditions for the As ion implantation are, for example, an ion energy of 70 KeV and a dose density of $5 \times 10^{15} cm^{-2}$. Thereafter the Si substrate 1 is subjected to a thermal treatment, in which the n-type impurities in source and drain regions 15 are activated. In this way, an n-channel MOS transistor is formed.

In the embodiment of Figs. 8, a $p^+$ region is induced by the negative fixed charges 6 near the surface region of the Si substrate 1 and directly below the gate electrode 14. By controlling the negative fixed charges in the gate insulation layer 11, threshold voltage $V_{th}$ of the n-channel transistor can be controlled to a desired value. The induced positive charges in the source and drain regions 15 are compensated by the n-type impurities which are provided at high density.

In the embodiment of Figs. 8, thermal treatment for making the Al atoms 5 in the polysilicon layer 4 pile up into the gate insulation layer 11 may be performed after the polysilicon layer 4 is patterned, forming the gate electrode 14. Further, this thermal treatment may be performed after the As ion implantation. In this way, Al segregation and activation of AS impurities can be effected in the same thermal treatment.

The control of $V_{th}$ can be applied for a p-channel MOS transistor, wherein source and drain regions 15 are formed by ion-implanting p-type impurities such as boron (B) on to an n-type silicon substrate 1. The p-channel MOS transistor produced in this way is generally of a normally-on type.

In accordance with the above embodiment, $V_{th}$ control of MOS transistors can be achieved without a direct implantation of impurities into the Si substrate 1, and damage of the gate insulation layer can be avoided. The polysilicon layer used as an impurity source for controlling $V_{th}$ can be utilised

as a gate electrode, which has the merit of not increasing the number of process steps needed.

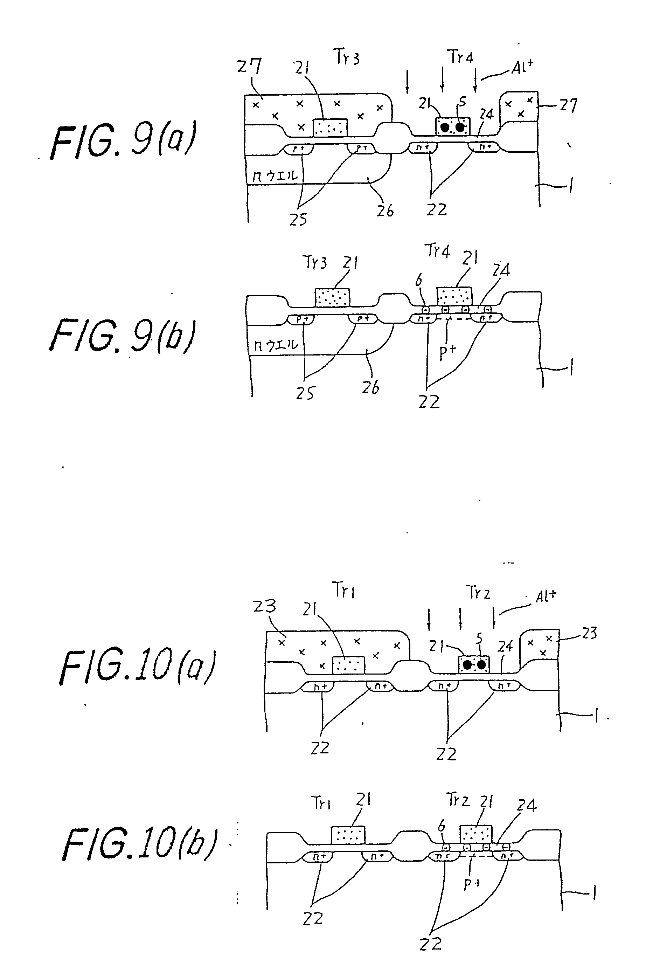

Figs. 9(a) and 9(b) illustrate a further embodiment of the present invention, wherein the present invention is applied for controlling voltage $V_{th}$ of an n-channel MOS transistor in a CMOS structure.

As shown in Fig. 9(a), an n-well 26 is formed in a p-type Si substrate 1. The CMOS structure is composed of a p-channel MOS transistor $Tr_3$ in the n-well 26 including $p^+$ source and drain regions 25 and an n-channel MOS transistor $Tr_4$ in the Si substrate 1 including $n^+$ source and drain regions 22. A resist layer 27 is formed on the surface of the Si substrate 1, with an opening which exposes the n-channel transistor $Tr_4$. Al ions are implanted through the opening. The Al ions are introduced into a gate electrode 21 of polysilicon. The Al ions are also implanted in the n-type source and drain regions 22 through an $SiO_2$ layer 24 acting as a gate insulation layer. However, because the necessary Al concentration for increasing $V_{th}$ is about 1 x $10^{18}$cm$^{-3}$, the effects of Al implanted in regions 22 is compensated by the n-type impurities in the source and drain regions 22.

Next, the resist layer 27 is removed and the Si substrate 1 is thermally treated. In this process, Al redistributes from the gate electrode 21 of n-channel transistor $Tr_4$ into the $SiO_2$ layer 24 formed thereunder and negative fixed charges are formed as shown in Fig. 9(b). Therefore, a $p^+$ region is induced in the channel region of n-channel transistor $Tr_4$ and the $V_{th}$ value rises, thus the $V_{th}$ value is controlled.

Figs. 10(a) and 10(b) show another embodiment of the present invention, in which the present invention is applied to a mask ROM structure. A plurality of MOS transistors are arranged in a single chip of a mask ROM, and selected MOS transistors thereof are controlled to have a normally-off characteristic whilst the rest of the MOS transistors are usually formed to have a normally-on characteristic. The above selection of MOS transistors is determined by a design of the memory pattern of the mask ROM.

As shown in Fig. 10(a), a plurality of MOS transistors having gate electrodes 21 (of polysilicon) and n-type source and drain regions 22 are formed in a Si substrate 1. In Fig. 10(a), only two MOS transistors $Tr_1$ and $Tr_2$ are shown. These transistors are formed having a normally-on characteristic. The transistor $Tr_2$ is to be subjected to a so-called write process to change its characteristic to a normally-off type.

A resist layer 23 is formed on the surface of silicon substrate 1, the resist layer having an opening on $Tr_2$, and Al ions are implanted through the opening. The object of this ion implantation is to introduce Al ions into polysilicon, and therefore the resist layer 23 is to be sufficient at least to mask the gate electrode 21 of transistor $Tr_1$ which is not to be subjected to a write process. Al which penetrates through an $SiO_2$ layer 24 provided as gate insulation layer is also implanted into the source and drain regions 22. However, because the necessary concentration of Al is about 1 x $10^{18}$cm$^{-3}$, which will make the $V_{th}$ value of transistor $Tr_2$ to a normally-off level, the effect of Al implanted in regions 22 is cancel led by the n-type impurities in the source and drain regions 22.

After removing resist layer 23, the Si substrate 1 is thermally treated and Al atoms 5 in the gate electrode 21 of $Tr_2$ are redistributed into the $SiO_2$ layer 24, forming negative fixed charges 6 as shown in Fig. 10(b). Then, in the channel region of $Tr_2$, a $p^+$ region is induced and the $V_{th}$ value is made higher and $Tr_2$ assumes a normally-off characteristic. Namely, the write process is completed.

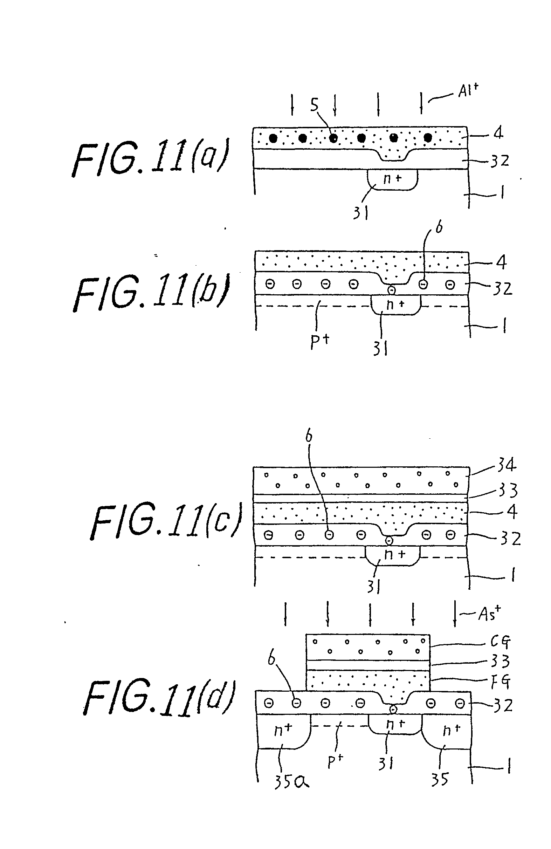

Figs. 11(a) to 11(d) illustrate a further embodiment of the present invention, applied for controlling a read voltage of an EEPROM (electrically erasable and programmable ROM), wherein a plurality of transistors are arranged in a matrix and selected transistors among them are controlled to have a different threshold voltage $V_{th}$ from other transistors.

Referring to Fig. 11(a), a gate insulation layer 32 is formed on a p-type Si substrate 1 wherein an n-type high-doped region 31 is formed which will subsequently become a write and erase electrode. The gate insulation layer 32 has a thickness of 300 to 500 Å except above the n-type high-doped region 31 where the thickness reduced to 70 to 100 Å for example. The thin portion is called a tunnel film. The method of forming the tunnel film is a known technique and has no relation to the present invention and therefore explanation is omitted here. After depositing a polysilicon layer 4 on the gate insulation layer 32, Al atoms 5 are ion implanted into the polysilicon layer 4. The implanting conditions may be the same as those used in the embodiments of Figs. 9 and 10.

Next, the silicon substrate 1 is thermally treated, during which the Al ions in the polysilicon layer 4 pile up in the gate insulation layer 32. Negative fixed charges 6 are formed in the gate insulation layer 32 as shown in Fig. 11(b), and a $p^+$ region is induced near the surface of the Si substrate 1. The negative fixed charges 6 in the gate insulation layer 32 have a concentration of less than $10^{13}$cm$^{-3}$ and the concentration of n-type region 31 having impurities of less than $10^{15}$cm$^{-3}$ will not change practically.

Next, as shown in Fig. 11(c), the surface of the polysilicon layer 4 is thermally oxidised, forming a $SiO_2$ layer 33 having a thickness of about 400 Å and thereafter a polysilicon layer 34 is deposited

on the $SiO_2$ layer 33. Using a known lithography technique, the polysilicon layer 34, the $SiO_2$ layer 33 and the polysilicon layer 4 are selectively etched away successively. As a result, as shown in Fig. 11(d), a double layer gate with a floating gate (FG) of polysilicon and a control gate (CG) of polysilicon layer 34 are formed. Thereafter, n-type impurities, As for example, are ion implanted into the Si substrate 1 using the control gate (CG) and the floating gate (FG) as a mask, forming a source region 35a and a drain region 35 in contact with n-type high-doped region 31, and the EEPROM is finished.

The read voltage, namely $V_{th}$, of the MOS transistor composed of the control gate (CG) and the n-type high-doped region 31 with the drain region 35 and the source region 35a can be controlled. In the prior art, it is controlled by p-type impurities ion implanted directly under the gate insulation layer 32. In the embodiment of the present invention, $V_{th}$ can be controlled by the $p^+$ region induced by the negative fixed charges 6 in the gate insulation layer 32. As a result, the difficulty of obtaining a predetermined withstanding voltage, which arises in the prior art, can be avoided. The difficulty is caused by damage during ion implantation to the thin portion of the gate insulation layer 32 on the n-type high-doped region 31.

In the above explanations of embodiments of the present invention, it is indicated that $SiO_2$ layers are formed on Si substrates as insulation layers. However, embodiments of the present invention may use other insulation material, such as $Si_3N_4$, therefor. Further, conductive layers of materials other than polysilicon, amorphous silicon for example, may be used on the $SiO_2$ (insulation) layers.

In an embodiment of the present invention, a polysilicon layer, for example, used as the Al diffusion source is not subjected to oxidation during heat treatment and, therefore, it can be effectively used as a conductive layer.

With methods embodying the present invention, impurity introduction into an insulation layer, for example of $SiO_2$, and formation of fixed charges therein, are not accompanied by the prior art problems.

In an MOS transistor, the insulation layer, e.g. the $SiO_2$ layer, can be used as a gate insulation film and the conductive layer, e.g. the polysilicon layer, used as a gate electrode. A $p^+$ layer induced in a channel region of an MOS transistor due to the segregated Al impurities in the gate insulation film, has a function of controlling threshold voltage value ($V_{th}$). Therefore, the $V_{th}$ can be controlled by changing the amount of Al impurities introduced into the conductive layer, e.g. polysilicon layer.

These features can be effectively applied in the process of forming a memory pattern of a mask ROM, and further applied in improving a withstanding voltage of transistors used in an EEPROM.

All embodiments described above utilise Al impurities. However, the impurity material used is not restricted to Al only. Ca and Sr impurities can be used for forming negative fixed charges, for example in $SiO_2$ layers, and B impurities can be used for forming positive fixed charges.

A manufacturing method embodying the present invention comprises the steps of:-
depositing an insulation layer on a silicon substrate and further a conductive layer thereon,
doping impurities in the conductive layer, the impurities being selected from the materials which are susceptible to segregate and pile up into the insulation layer, and
heat treating the substrate, thereby the impurities being redistributed into the insulation layer and negative (or positive) fixed charges being formed in the insulation layer, resulting in preventing a formation of a depletion/inversion layer in the silicon substrate adjacent to the interface between the silicon substrate and the insulation layer.

When a p-type silicon substrate is used, aluminium, calcium or strontium impurities may be introduced in the conductive layer and negative fixed charges are formed in the insulation layer. When an n-type silicon substrate is used, boron impurities may be used for forming positive fixed charges.

The conductive layer used as an impurities source may be subsequently utilised as a conductive electrode of a semiconductor device.

## Claims

1. A method of manufacturing a semiconductor device, the device comprising a silicon substrate (1) and an insulation layer (2; 2b; 11; 24; 32) formed on the substrate, the method comprising:-
   depositing a conductive layer (4; 21) on the insulation layer (2; 2b; 11; 24; 32), which conductive layer (4; 21) is doped with an impurity material (5);
   carrying out heat treatment such that the impurity material (5) segregates and accumulates in the insulation layer (2) and fixed charges (6) are formed in the insulation layer (2; 2b; 11; 24; 32).

2. A method as claimed in claim 1, wherein the silicon substrate (1) is a p-type substrate and the impurity material (5) is aluminium, calcium or strontium, negative fixed charges (6) being formed in the insulation layer (2; 2b; 11; 24; 32).

3. A method as claimed in claim 1, wherein the silicon substrate (1) is a n-type substrate and the impurity material (5) is boron, positive fixed charges (6) being formed in the insulation layer (2; 2b; 11; 24; 32).

4. A method as claimed in claim 1, 2 or 3, wherein the conductive layer (4; 21) is deposited then the impurity material (5) doped into the conductive layer (4; 21), for example by ion implantation.

5. A method as claimed in claim 1, 2, 3 or 4, wherein the heat treatment is carried out at a predetermined temperature in an inactive atmosphere.

6. A method as claimed in any preceding claim; the semiconductor device comprising a trench isolation structure, the method comprising:-
forming a trench (3) in the silicon substrate (1) and forming the insulation layer (2; 2b) on the surface of the trench walls and on the surface of the silicon substrate (1),
depositing the conductive layer (4) to fill the trench (3),
the fixed charges being formed also in the insulation layer (2; 2b) on the surface of the trench walls, improving isolation characteristics between adjacent element-forming areas on opposite sides of the trench in the semiconductor device.

7. A method as claimed in any of claims 1 to 5, the semiconductor device comprising a field isolation region including the insulation layer (2) and the conductive layer (4) on the silicon substrate (1), wherein the fixed charges (6) in the insulation layer (2) isolate two diffusion regions formed on opposite sides of the field isolation region.

8. A method as claimed in any one of claims 1 to 5, the semiconductor device comprising a channel region, a gate insulation layer (11; 24) and a gate electrode (4; 14; 21) of a MIS (metal insulator semiconductor) transistor, the method comprising:-
patterning the conductive layer (4) after the heat treatment, thereby to form the gate electrode (14; 21) on the insulation layer (11; 24) which provides the gate insulation layer with the fixed charges (6), and
introducing impurities of opposite type to the type of the substrate (1), to form a source region (15; 22, 25) and a drain region (15; 22, 25) of the MIS transistor, whereby the channel region is formed between the source and drain regions (15; 22, 25) under the gate insulation layer (11; 24), and
whereby the fixed charges (6) formed in the gate insulation layer (11) function to control a threshold voltage of the MIS transistor.

9. A method as claimed in any one of claims 1 to 5, the semiconductor device comprising a plurality of MIS transistors arranged in a matrix forming a mask ROM, selected transistors among said plurality of transistors having a normally-off characteristic and the remaining transistors of said plurality having a normally-on characteristic, the method comprising:-
forming said plurality of MIS transistors after deposition of the conductive layer (21), the conductive layer (21) being patterned to form gate electrodes (21) of each MIS transistor of said plurality, and source regions (22) and drain (22) region of each of said plurality of MIS transistors being formed,
forming a resist layer (23) on said plurality of MIS transistors,
patterning the resist layer (23) and exposing the selected MIS transistors, and
subjecting the gate electrodes (21) of the selected MIS transistors to doping with the impurity material (5) and thereafter subjecting the substrate (1) to the heat treatment,
whereby characteristics of said selected transistors are changed to normally-off and the remaining transistors of said plurality, covered with said resist layer (23) during the doping, retain a normally-on characteristic.

10. A method as claimed in any one of claims 1 to 5, the semiconductor device comprising a plurality of MIS transistors arranged in a matrix, each of said plurality of MIS transistors having a double gate comprising a floating gate (FG) and a control gate (CG), and floating gates of selected MIS transistors being electrically charged during a write process forming an EEPROM, the method comprising:-
forming a highly doped region (31) adjacent to a drain region (35) in the silicon substrate (1) and forming a tunnel film region thereon in said insulation layer (32) for each of said plurality of MIS transistors, before deposition of the conductive layer (4),
forming a further insulation layer (33) on said conductive layer (4) after the heat treatment,
forming a further conductive layer (34) on the further insulation layer (33),
patterning the conductive layer (4), the further insulation layer (33) and the further conductive layer (34), whereby said floating gate (FG) and said control gate (CG) are formed respectively from the conductive layer (4) and the further conductive layer (34) in respect of each of said plurality of MIS transistors, and

introducing impurities into said silicon substrate (1) on opposite sides of said floating (FG) and control (CG) gates, to form source region (35a) and drain (35) regions of each of said plurality of MIS transistors, and

threshold voltage of each of said plurality of the MIS transistors being controlled by said fixed charges (6) formed in said insulation layer (32).

11. A method as claimed in any preceding claim, wherein the insulation layer (2; 26; 11; 24; 32) is a silicon dioxide layer.

12. A method as claimed in any preceding claim, wherein said conductive layer (4; 21) is a silicon layer, for example of polysilicon or amorphous silicon.

13. A method as claims in claim 2, or any of claims 4 to 11 read as dependent on claim 2, wherein the impurity material is aluminium and the heat treatment is carried out at a predetermined temperature of about 950 to 1000° C.

FIG. 1(a)

FIG. 1(b)

FIG. 1(c)

FIG. 2(a)

FIG. 2(b)

FIG. 2(c)

FIG. 3 (a)

FIG. 3 (b)

FIG. 4(a)

FIG. 4(b)

FIG. 4(c)

FIG. 4(d)

FIG. 4(e)

FIG. 5

FIG. 6(a)

FIG. 6(b)

FIG. 6(c)

FIG. 6(d)

FIG. 6(e)

FIG. 7

FIG. 8(a)

FIG. 8(b)

FIG. 8(c)

FIG. 9(a)

FIG. 9(b)

FIG. 10(a)

FIG. 10(b)

FIG.11(a)

FIG.11(b)

FIG.11(c)

FIG.11(d)